# EUROPÄISCHE PATENTANMELDUNG

(11) **EP 2 048 695 A2**
(43) Veröffentlichungstag der Anmeldung: **15.04.2009**
(21) Anmeldenummer: 08164787.7
(22) Anmeldetag: 22.09.2008
(51) Int. Cl.: H01L 21/00

(54) **Aufnehmen einer Mehrzahl von elektronischen Bauelementen mittels Saugkanälen mit pneumatischem Verstellelement**

(30) Priorität: 09.10.2007 DE 102007048414
(71) Anmelder: Siemens Aktiengesellschaft, 80333 München (DE)
(72) Erfinder: Brandis, Tilo, 81479, München (DE); Fricke, Christian, 85221, Dachau (DE); Trebes, Daniel, 32676 Luegde (DE)

(57) **Zusammenfassung**

Es wird eine Vorrichtung (100) zum gleichzeitigen Aufnehmen einer Mehrzahl von elektronischen Bauelementen (152) beschrieben. Die Vorrichtung (100) ist insbesondere zum gleichzeitigen Aufnehmen von Halbleiter-Chips (152) aus einer Wafer-Anordnung geeignet, welche eine Trägerfolie (150) und an der Trägerfolie (150) anhaftende Halbleiter-Chips (152) aufweist. Die Vorrichtung (100) weist ein Grundelement (110), welches eine Mehrzahl von Saugkanälen (112) aufweist, die sich von einer Vorderseite (115) des Grundelements (110) hin zu einer Rückseite (116) des Grundelements (110) erstrecken, und eine Mehrzahl von pneumatischen Verstellelementen (120) auf, welche jeweils einem Saugkanal (112) zugeordnet sind. Die pneumatischen Verstellelemente (120) sind jeweils derart eingerichtet, dass ein durch den jeweiligen Saugkanal (112) strömender Luftstrom zumindest teilweise blockiert wird, wenn die Stärke des Luftstromes einen vorgegebenen Schwellenwert überschreitet. Es wird ferner ein Verfahren zum gleichzeitigen Aufnehmen einer Mehrzahl von elektronischen Bauelementen (152) beschrieben, welches Verfahren die oben beschriebene Bauelement-Aufnahmevorrichtung verwendet.

## Beschreibung

Die vorliegende Erfindung betrifft das Gebiet der Handhabung von elektronischen Bauelementen, insbesondere von Halbleiter-Chips, welche nach einem Vereinzelungsvorgang aus einem fertig prozessierten Wafer an einer klebrigen Trägerfolie einer Wafer-Anordnung anhaften. Die vorliegende Erfindung betrifft insbesondere eine Vorrichtung und ein Verfahren zum gleichzeitigen Aufnehmen einer Mehrzahl von elektronischen Bauelementen bzw. Halbleiter-Chips aus einer Wafer-Anordnung, welche eine Trägerfolie und die an der Trägerfolie anhaftende Bauelementen bzw. Halbleiter-Chips aufweist.

Aufgrund der zunehmenden Miniaturisierung von elektronischen Bauelementen wird es bereits in naher Zukunft nicht mehr wirtschaftlich sein, elektronische Bauelemente, welche auf ein elektronisches Schaltungssubstrat bestückt werden sollen, zum Zwecke einer sicheren Bauelement-Zuführung für einen Bestückprozess umzupacken. Ein derartiges Umpacken in spezielle Bauelement-Zuführgurte wird häufig angewendet, um die Bauelemente einzeln dem Bestückprozess zuzuführen. Von modernen SMT-Bestücksystemen wird vielmehr schon bald verlangt werden, dass sie die zu bestückenden Bauelemente unmittelbar von einem Wafer einzeln entnehmen und auf entsprechende Stellen eines elektronischen Schaltungssubstrats aufsetzen.

Um die Handhabung von elektronischen Bauelementen, welche als so genannte Flip-Chips unmittelbar aus einer Wafer-Anordnung entnommen werden sollen, zu vereinfachen, wird der gesamte Wafer vor einer Bauelement-Vereinzelung an einer klebrigen Trägerfolie angebracht. Die Vereinzelung erfolgt beispielsweise durch einen hochpräzisen mechanischen Säge- und/oder durch einen chemischen Ätzvorgang.

Von der Trägerfolie können die Bauelemente von einem Sauggreifer entnommen und einem Bestückprozess zugeführt werden. Um einen Ablösevorgang der Bauelemente von der klebrigen Trägerfolie zu erleichtern, ist aus der EP 565781 A1 eine Ausstoßvorrichtung zum Abtrennen eines Chips von einem klebrigen Träger bekannt, welche Ausstoßvorrichtung eine spitze Ausstoßnadel aufweist, die die Trägerfolie durchdringt und ein Ablösen des jeweiligen Bauelements mittels eines Sauggreifers unterstützt.

Aus der DE 102005036821 A1 ist eine ein Verfahren zum Transferieren von elektronischen Bauelementen von einer klebrigen Trägerfolie auf einen Bestückkopf eines Bestückautomaten bekannt. Das Verfahren umfasst (a) einen Transfer der Trägerfolie zu einer Vakuumaufnahmevorrichtung, welche eine ebene und mit Öffnungen versehene Ansaugfläche aufweist, wobei eine mit den Bauelementen versehene Seite der Trägerfolie der Ansaugfläche zugewandt ist, (b) ein Anlegen eines Unterdrucks an die Vakuumaufnahmevorrichtung, so dass die Bauelemente von der Ansaugfläche angesaugt werden, (c) ein Reduzieren der Klebrigkeit der Trägerfolie, so dass die von der Trägerfolie auf die Bauelemente vermittelte Klebekraft kleiner ist als die von der Vakuumaufnahmevorrichtung auf die Bauelemente vermittelte Ansaugkraft, (d) ein Entfernen der Trägerfolie von der Vakuumaufnahmevorrichtung, wobei die Bauelemente auf der Vakuumaufnahmevorrichtung verbleiben, und (e) ein Aufnehmen der Bauelemente durch einen Transportkopf, welcher zumindest eine Bauelement-Haltevorrichtung aufweist. Das beschriebene Verfahren hat den Nachteil, dass in den Bereichen der Vakuumaufnahmevorrichtung, in denen keine Bauelemente an der Ansaugfläche anliegen, die Öffnungen freiliegen. Dadurch wird der Verbrauch an Saugluft durch die für die Bauelement-Halterung ungenutzten Luftströme der freiliegenden Öffnungen erhöht. Dies wiederum führt zu hohen Betriebskosten.

Der Erfindung liegt die Aufgabe zugrunde, eine Vorrichtung und ein Verfahren zum gleichzeitigen pneumatischen Aufnehmen einer Mehrzahl von elektronischen Bauelementen zu schaffen, welche hinsichtlich des Verbrauchs an Saugluft eine hohe Effizient aufweisen.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird eine Vorrichtung zum gleichzeitigen Aufnehmen einer Mehrzahl von elektronischen Bauelementen beschrieben. Die Vorrichtung eignet sich insbesondere zum gleichzeitigen Aufnehmen von Halbleiter-Chips aus einer Wafer-Anordnung, welche eine Trägerfolie und an der Trägerfolie anhaftende Halbleiter-Chips aufweist. Die beschriebene Bauelement-Aufnahmevorrichtung weist auf (a) ein Grundelement, welches eine Mehrzahl von Saugkanälen aufweist, die sich von einer Vorderseite des Grundelements hin zu einer Rückseite des Grundelements erstrecken, und (b) eine Mehrzahl von pneumatischen Verstellelementen, welche jeweils einem Saugkanal zugeordnet sind. Erfindungsgemäß sind die pneumatischen Verstellelemente jeweils derart eingerichtet, dass ein durch den jeweiligen Saugkanal strömender Luftstrom zumindest teilweise blockiert wird, wenn die Stärke des Luftstromes einen vorgegebenen Schwellenwert überschreitet.

Der beschriebenen pneumatischen Bauelement-Aufnahmevorrichtung liegt die Erkenntnis zugrunde, dass der Luftverbrauch, welcher zum sicheren Halten mehrerer Bauelemente erforderlich ist, auf vorteilhafte Weise dadurch begrenzt werden kann, dass sog. freie Saugkanäle, an deren vorderer Öffnung an der Vorderseite des Grundelements sich kein Bauelement befindet, zumindest teilweise verschlossen werden.

Dadurch können zur Aufnahme der Bauelemente die Saugkanäle in einem beliebigen, möglichst feinen Raster angeordnet sein. Es ist jedenfalls nicht erforderlich, dass die räumliche Anordnung der Saugkanäle an die räumliche Anordnung der aufzunehmenden Bauelemente angepasst ist. Damit kann die beschriebene pneumatische Bauelement-Aufnahmevorrichtung für verschieden große und/oder in verschiedenen Rastern angeordnete Wafer-Anordnungen verwendet werden.

Im Vergleich zu den mit einem Bauelement versehenen Saugkanälen wird der Luftstrom durch einen freien Saugkanal bei vergleichbaren pneumatischen Verhältnissen deutlich größer sein. Somit kann die Stärke des Luftstromes als Indikator für die Anwesenheit eines Bauelements an der vorderen Öffnung eines Saugkanals dienen. Durch eine entsprechende Aktion des jeweiligen Verstellelements können somit selektiv diejenigen Saugkanäle zumindest teilweise verschlossen werden, welche im unverschlossenen Fall einen hohen Verbrauch an Saugluft verursachen würden. Damit kann die Effizient der kollektiven Bauelement-Aufnahme hinsichtlich des Verbrauchs an Vakuumluft bzw. Saugluft erheblich verbessert werden.

Die pneumatischen Verstellelemente können beispielsweise aktiv durch entsprechende Stellglieder betätigt werden. Die Stellglieder können in geeigneter Weise jeweils mit einem Sensor zur Messung der Stärke des Luftstromes durch den jeweiligen Saugkanal gekoppelt sein.

Gemäß einem Ausführungsbeispiel der Erfindung nach Anspruch 2 sind die Saugkanäle in einem eindimensionalen oder in einem zweidimensionalen Raster angeordnet. Das Raster kann dabei so fein sein, dass auch sehr kleine Bauelemente mit einer geringen Beabstandung voneinander zuverlässig aufgenommen werden können. Dies ist auf alle Fälle dann gegeben, wenn jedem aufzunehmenden Bauelement zumindest ein Saugkanal zugeordnet ist.

Eine feine Rasterung der Saugkanäle ist aufgrund der Tatsache, dass sich freie Saugkanäle durch eine geeignete Betätigung der jeweiligen Verstellelemente selbst verschleißen, auch dann nicht nachteilig, wenn die Bauelemente mit einem größeren Abstand zueinander aufgenommen werden. Eine größere Beabstandung der Bauelemente voneinander kann beispielsweise durch eine gezielte Dehnung einer elastischen Trägerfolie vor der Übergabe der Bauelemente an die pneumatische Aufnahmevorrichtung erfolgen. Dadurch können die Bauelemente später einzeln beispielsweise von einem Sauggreifer übernommen werden, ohne dass ein versehentliches Anstoßen des Sauggreifers an einem benachbarten Bauelement zu besorgen ist.

Eine feine Rasterung der Saugkanäle hat ferner den Vorteil, dass das pneumatische Bauelement-Aufnahmeelement zur Aufnahme von Bauelementen von unterschiedlich gedehnten Trägerfolien verwendet werden kann. Dies ist insbesondere nach einer Entnahme von einem oder von mehreren Bauelementen von der Trägerfolie vorteilhaft, da sich die Elastizität der Trägerfolie durch die Entnahme von starren Bauelementen erhöht und bei einer gleichbleibenden Spannung der Trägerfolie der Abstand von Bauelement zu Bauelement und insbesondere die Positionen der verbliebenen Bauelemente verändert.

Gemäß einem weiteren Ausführungsbeispiel der Erfindung nach Anspruch 3 weist die pneumatische Bauelement-Aufnahmevorrichtung zusätzlich einen gemeinsamen Ansaugstutzen auf, welcher an der Rückseite des Grundelements angeordnet ist und welcher pneumatisch mit der Mehrzahl von Saugkanälen gekoppelt ist.

Durch die Verwendung eines gemeinsamen Ansaugstutzens können mehrere Saugkanäle mit Unterdruck beaufschlagt werden, wobei die Saugkanäle auf vorteilhafte Weise den gleichen Druckverhältnissen ausgesetzt sein können. Unter der Vorraussetzung, dass alle Saugkanäle den gleichen Strömungswiderstand aufweisen, beispielsweise weil sie in identischer Weise dimensioniert sind, kann die pneumatische Anwesenheitskontrolle für alle Saugkanäle in der gleichen Weise durchgeführt werden.

Der gemeinsame Ansaugstutzen kann einen Vakuumanschluss aufweisen, welcher pneumatisch mit einer Vakuum- bzw. Unterdruckerzeugungseinheit gekoppelt sein kann.

Gemäß Anspruch 4 weist die Vorderseite des Grundelements eine plane Oberfläche auf. Dies hat den Vorteil, dass das Grundelement gleichmäßig an die Oberflächen der elektronischen Bauelemente innerhalb einer ebenen Wafer-Anordnung angelegt werden kann. Dadurch kann eine zuverlässige Aufnahme der einzelnen elektronischen Bauelemente gewährleistet werden und so die Prozesssicherheit bei der Handhabung der elektronischen Bauelemente erhöht werden.

Das Grundelement kann beispielsweise eine Platte sein, welche planparallele Oberflächen aufweist. Dabei entspricht eine Oberfläche der Vorderseite des Grundelements und die andere Oberfläche entspricht der Rückseite des Grundelements. Die Verwendung einer planparallelen Platte als Grundform für das Grundelement hat den Vorteil, dass das Grundelement und damit die gesamte pneumatische Aufnahmevorrichtung auf einfache Weise hergestellt werden kann.

Gemäß Anspruch 5 sind die pneumatischen Verstellelemente passive Komponenten. Dies bedeutet, dass die Verstellelemente jeweils ein ungesteuertes bzw. ungeregeltes mechanisches System darstellen. Damit kann die beschriebene pneumatische Bauelementaufnahmevorrichtung auf effektive Weise ohne den Einsatz von aufwendigen Steuer- bzw. Regelkomponenten lediglich mit einfachen Komponenten realisiert werden.

Gemäß Anspruch 6 sind die pneumatischen Verstellelemente innerhalb der Saugkanäle angeordnet. Dies hat den Vorteil, dass die gesamte Verstellmechanik für die Saugkanäle in dem Grundelement integriert ist. Auf diese Weise kann die pneumatische Bauelement-Aufnahmevorrichtung innerhalb einer kompakten Bauform realisiert werden.

Um die pneumatischen Verstellelemente mit voller Funktionalität in die Säugkanäle integrieren zu können, kann jeder Saugkanal jeweils eine Aufweitung aufweiten, in der jeweils das dem betreffenden Saugkanal zugeordnete Verstellelement verschiebbar gelagert ist.

Gemäß Anspruch 7 sind die pneumatischen Verstellelemente verschiebbare Verschlusselemente. Diese Verstellelemente erfahren jeweils durch eine mechanische Vorspannung eine Kraft in Richtung einer Ausgangsposition, in der der jeweilige Saugkanal offen ist. Ferner können die Verstellelemente jeweils durch eine Luftströmung innerhalb des jeweiligen Saugkanals bei einer Überkompensation der mechanischen Vorspannung in eine Verschlussposition gedrückt werden, in der der jeweilige Saugkanal zumindest teilweise geschlossen ist.

Dies bedeutet, dass durch eine vergleichweise starke Luftströmung die pneumatischen Verstellelemente von der Ausgangsposition in die Verschlussposition gedrückt werden, in der der Luftstrom dann durch den zumindest teilweisen Verschluss des Saugkanals zum Erliegen kommt. Das Verschlusselement wird jedoch infolge des weiterhin anliegenden Unterdrucks auch bei einem vollständigen Verschluss des Saugkanals weiter in der Verschlussposition gehalten. Erst wenn der Unterdruck am Ausgang des Saugkanals an der Rückseite des Grundelements abgeschaltet oder zumindest deutlich reduziert wird, wird sich das Verstellelement infolge der mechanischen Vorspannung wieder in die Ausgangsposition bewegen.

Das Verschlusselement kann jede Form aufweisen, die geeignet ist, den Saugkanal zumindest teilweise zu verschließen. Dies bedeutet, dass die äußere Form des Verschlusselements in geeigneter Weise an die innere Form des Saugkanals angepasst ist. Im einfachsten Fall ist das Verschlusselement eine einfache Kugel, welche in einer Aufweitung des jeweiligen Saugkanals gelagert ist. In der Verschlussposition verschließt die Kugel den Saugkanal im Bereich der Verjüngung zwischen der Aufweitung und dem dünneren Bereich des Saugkanals zumindest teilweise. Das Verschlusselement kann jedoch auch eine Nadel sein, welche bei einer entsprechenden Verschiebung den jeweiligen Saugkanal verschließt.

Gemäß Anspruch 8 weist die pneumatische Bauelement-Aufnahmevorrichtung zusätzlich auf eine Mehrzahl von Federelementen zur Erzeugung der mechanischen Vorspannungen. Dies hat den Vorteil, dass die verschiebbaren Verschlusselemente mit einer definierten Kraft in ihre Ausgangsposition gedrückt und/oder gezogen werden. Diese Kraft ist bevorzugt deutlich größer als die Gewichtskraft eines einzelnen Verschlusselements. Dies hat den Vorteil, dass die gesamte pneumatische Bauelement-Aufnahmevorrichtung in Bezug auf die Gewichtskraft in verschiedenen Orientierungen zuverlässig betrieben werden kann.

Es wird darauf hingewiesen, dass die mechanische Vorspannung auch lediglich durch die Gewichtskraft des jeweiligen Verschlusselements erzeugt werden kann. In diesem Fall ist es jedoch erforderlich, dass die pneumatische Bauelement-Aufnahmevorrichtung in einer festen räumlichen Orientierung betrieben wird.

Mit dem Anspruch 9 wird ein Verfahren zum gleichzeitigen Aufnehmen einer Mehrzahl von elektronischen Bauelementen beschrieben, welches Verfahren insbesondere zum gleichzeitigen Aufnehmen von Halbleiter-Chips aus einer Wafer-Anordnung geeignet ist. Das beschriebene Verfahren weist auf (a) ein Heranführen einer oben beschriebenen Vorrichtung zum gleichzeitigen Aufnehmen einer Mehrzahl von aufzunehmenden elektronischen Bauelementen, welche an einer Trägerfolie anhaften, so dass die Vorderseite des Grundelements an der Oberseite der Bauelemente anliegt, (b) ein Anlegen eines Unterdrucks an die Mehrzahl von Saugkanälen, so dass die Bauelemente an der Vorderseite des Grundelements angesaugt werden, und (c) ein Entfernen der Trägerfolie von der Bauelement-Aufnahmevorrichtung, wobei die Bauelemente an der Bauelement-Aufnahmevorrichtung verbleiben.

Der beschriebenen pneumatischen Bauelement-Aufnahmeverfahren liegt die Erkenntnis zugrunde, dass die oben beschriebene Vorrichtung zum gleichzeitigen Aufnehmen einer Mehrzahl von elektronischen Bauelementen auch ohne eine hochgenaue relative Positionierung zwischen den Saugkanälen und den aufzunehmenden Bauelementen verwendet werden kann, um die Bauelemente auf sichere Weise aufzunehmen. Dabei wird bevorzugt der Abstand zwischen den einzelnen Saugkanälen so klein gewählt, dass jedes aufzunehmende Bauelement zumindest von einem Saugkanal bzw. den in dem Saugkanal ausgebildeten Unterdruck gehalten wird. Der Verbrauch an Saugluft wird auf vorteilhafte Weise durch ein automatisches Verschließen derjenigen Saugkanäle reduziert, an denen kein Bauelement anliegt.

Die beschriebene pneumatische Bauelement-Aufnahmevorrichtung kann auf vorteilhafte Weise für verschieden große und/oder in verschiedenen Rastern angeordnete Wafer-Anordnungen verwendet werden. Eine Anpassung der Beabstandung der einzelnen Saugkanäle voneinander ist nicht erforderlich.

Vor dem Entfernen der Trägerfolie kann eine Klebrigkeit der Trägerfolie in bekannter Weise beispielsweise durch den Einfluss von UV-Strahlung und/oder Wärme reduziert werden. Auf diese Weise kann die Wahrscheinlichkeit erheblich reduziert werden, dass die Klebekraft der Trägerfolie stärker ist als die durch die Saugkanäle übertragene Ansaugkraft. In diesem Fall würden die Bauelemente nämlich ungewollt an der Trägerfolie verbleiben.

Gemäß einer Weiterbildung der Erfindung nach Anspruch 10 weist das Verfahren zusätzlich auf ein Abholen der Bauelemente durch einen Bestückkopf eines Bestückautomaten, wobei der Bestückkopf mindestens eine Bauelement-Haltevorrichtung zum Aufnehmen eines elektronischen Bauelements aufweist. Dies hat den Vorteil, dass kollektiv von einer Wafer-Anordnung übernommene Bauelemente direkt einem Bestückvorgang, welcher in bekannter Weise von einem Bestückautomaten durchgeführt wird, übergeben werden können.

Gemäß Anspruch 11 weist das Verfahren zusätzlich auf ein Wenden der oben beschriebenen Bauelement-Aufnahmevorrichtung zusammen mit der Mehrzahl von aufgenommenen Bauelementen. Dies hat den Vorteil, dass die Bauelemente, welche ursprünglich an der nach unten gerichteten Vorderseite des Grundelements aufgenommen sind, sich nach dem Wenden an der nach oben gerichteten Vorderseite befinden. Damit können die derart kollektiv gewendeten Bauelemente in bekannter Weise von einem Bestückkopf eines herkömmlichen Bestückautomaten abgeholt werden.

Weitere Vorteile und Merkmale der vorliegenden Erfindung ergeben sich aus der folgenden beispielhaften Beschreibung einer derzeit bevorzugten Ausführungsform. Die einzelnen Figuren der Zeichnung dieser Anmeldung sind lediglich als schematisch und als nicht maßstabsgetreu anzusehen.

Die Figuren 1a, 1b und 1c zeigen in einer Querschnittsdarstellung die Aufnahme von mehreren Halbleiter-Chips von einer Trägerfolie mittels einer pneumatischen Bauelement-Aufnahmevorrichtung und ein nachfolgendes Wenden der Bauelement-Aufnahmevorrichtung zusammen mit den aufgenommenen Bauelementen.

Die Figur 2 zeigt in einer Draufsicht eine pneumatische Bauelement-Aufnahmevorrichtung mit einer Vielzahl von Saugkanälen, wobei von einigen Saugkanälen jeweils ein Halbleiter-Chip aufgenommen ist.

An dieser Stelle bleibt anzumerken, dass sich in der Zeichnung die Bezugszeichen von gleichen oder von einander entsprechenden Komponenten lediglich in ihrer ersten Ziffer unterscheiden.

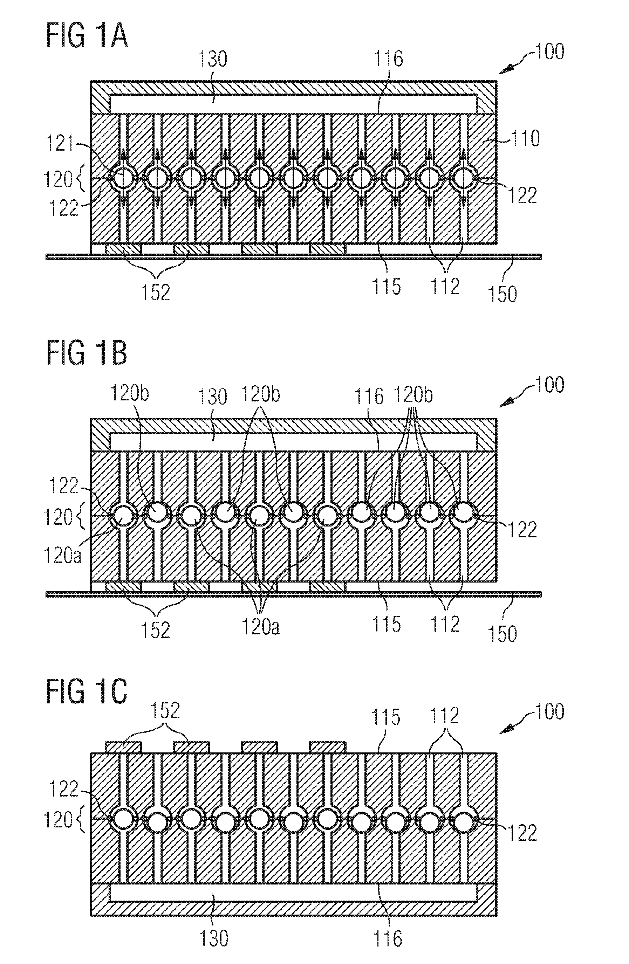

Figur 1a zeigt in einer Querschnittsdarstellung eine pneumatische Bauelement-Aufnahmevorrichtung 100 gemäß einem bevorzugten Ausführungsbeispiel der Erfindung. Die Bauelement-Aufnahmevorrichtung 100 weist ein Grundelement 110 auf, in dem eine Mehrzahl von Saugkanälen 112 ausgebildet ist. Die Saugkanäle 112 erstrecken sich von einer planen Vorderseite 115 des Grundelements 110 bis hin zu einer ebenfalls planen Rückseite 116 des Grundelements.

In der Mitte des Grundelements 110 weisen die Saugkanäle 112 jeweils eine Aufweitung auf, in der ein pneumatisches Verstellelement 120 in vertikaler Richtung verschiebbar gelagert ist. Die möglichen Verschiebungen der pneumatischen Verstellelemente 120 sind durch die Doppelpfeile 121 gekennzeichnet.

Die pneumatischen Verstellelemente 120 werden jeweils durch ein Federelement 122 in eine Ausgangsstellung gehalten. In dieser Ausgangsstellung ist der Saugkanal geöffnet, d.h. ein Luftstrom kann durch den Saugkanal 120 strömen.

Gemäß dem hier dargestellten Ausführungsbeispiel sind die pneumatischen Verstellelemente 120 jeweils Kugeln, welche an den Durchmesser der Saugkanäle 112 derart angepasst sind. Bei einer entsprechenden Verschiebung der Kugel 120 hin zu einer Verschlussposition liegt diese dann an dem Übergang zwischen der Aufweitung und dem Hals des Saugkanals an und verschließt den Saugkanal.

Die Bauelement-Aufnahmevorrichtung 100 weist ferner einen gemeinsamen Ansaugstützen 130 auf, welcher einen nicht dargestellten Vakuumanschluss aufweist. Über den Vakuumanschluss ist der Ansaugstutzen 130 mit einer ebenfalls nicht dargestellten Vakuumerzeugungsvorrichtung gekoppelt. Diese kann einen Unterdruck erzeugen, der über den gemeinsamen Ansaugstutzen an sämtlichen Saugkanälen 112 anliegt.

Zur Aufnahme einer Mehrzahl von elektronischen Bauelementen bzw. Halbleiter-Chips 152 von einer Trägerfolie 150 wird die Vorderseite 115 des Grundelements 110 an die Oberseite der aufzunehmenden Bauelemente 152 angelegt.

In Figur 1b ist dargestellt, wie sich die Positionen der einzelnen pneumatischen Verstellelemente 120 infolge unterschiedlich starker Luftströmungen in den Saugkanälen 112 verändern. In den sog. freien Saugkanälen, an deren vorderer Saugöffnung sich kein Bauelement 152 befindet, wird sich eine starke Luftströmung ausbilden. Diese Luftströmung, welche die jeweilige Kugel 120 umströmt, führt zu einer pneumatischen Kraft, welche die Kugel 120 nach oben in die Verschlussposition schiebt und so den betreffenden Saugkanal verschließt. Die nach oben verschobenen Kugeln, welche sich in der Verschlussposition befinden, sind in Figur 1b mit dem Bezugszeichen 120b gekennzeichnet. Durch die Schließung der freien Saugkanäle wird ein unnützer Verbrauch von Saugluft auf effektive Weise verhindert.

In den anderen Saugkanälen, an deren vorderer Saugöffnung ein Bauelement 152 anliegt, wird sich keine oder zumindest eine deutlich schwächere Luftströmung ausbilden. Dies hat zur Folge, dass die entsprechenden Kugeln infolge der Federkraft der Federelemente 122 in der Ausgangsposition gehalten werden, so dass der jeweilige Saugkanal 112 geöffnet bleibt. Die nicht verschobenen Kugeln, welche sich in der Ausgangsposition befinden, sind in Figur 1b mit dem Bezugszeichen 120a gekennzeichnet. Ein Unterdruck innerhalb des gemeinsamen Ansaugstutzens 130 liegt somit beständig an den Bauelementen 152 an, so dass diese zuverlässig gehalten und durch ein Wegbewegen der Trägerfolie 150 von der pneumatischen Bauelement-Aufnahmevorrichtung 100 von der Trägerfolie 150 entfernt werden können.

Um eine Bauelement-Übergabe an einen Bestückkopf eines Bestückautomaten in herkömmlicher Weise zu ermöglichen, wird nach der kollektive Aufnahme der Bauelemente 152 die pneumatische Bauelement-Aufnahmevorrichtung 100 zusammen mit den aufgenommenen Bauelementen 152 gewendet. Figur 1c zeigt die pneumatische Bauelement-Aufnahmevorrichtung 100 nach einem entsprechenden Wendevorgang. Nach dem Wenden befinden sich die Bauelemente, welche ursprünglich an der nach unten gerichteten Vorderseite des Grundelements aufgenommen sind, an der nach oben gerichteten Vorderseite.

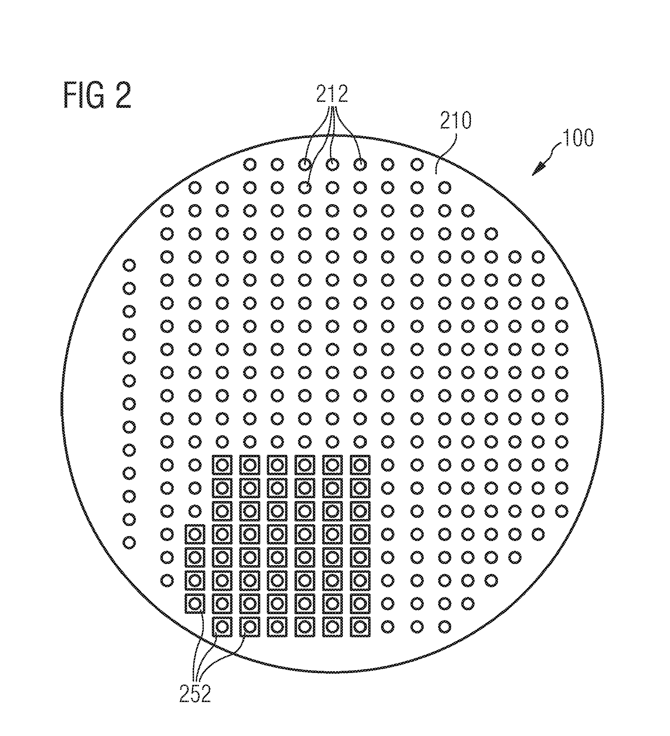

Figur 2 zeigt in einer Draufsicht die pneumatische Bauelement-Aufnahmevorrichtung, welche nun mit dem Bezugszeichen 200 versehen ist. An der Vorderseite des Grundelements 210 ist eine Vielzahl von Saugkanälen 212 zu erkennen. Vor einigen Saugkanälen 212 befinden sich Halbleiter-Chips 252, welche durch eine durch die jeweiligen Saugkanäle 212 vermittelte Ansaugkraft gehalten werden. Die freien Saugkanäle 212, an deren vorderer Öffnung sich kein Bauelement 252 befindet, sind jeweils durch ein nicht dargestelltes pneumatisches Verstellelement verschlossen. Auf diese Weise wird eine sog. Fehlluft, welche in Abwesenheit eines pneumatischen Verstellelements durch die freien Saugkanäle strömen würde, erheblich reduziert.

Bezugszeichenliste
- 100: pneumatische Bauelement-Aufnahmevorrichtung
- 110: Grundelement
- 112: Saugkanal
- 115: Vorderseite
- 116: Rückseite
- 120: pneumatisches Verstellelement / verschiebbares Verschlusselement / Kugel
- 120a: pneumatisches Verstellelement in Ausgangsposition
- 120b: pneumatisches Verstellelement in Verschlussposition
- 121: Verschieberichtung
- 122: Federelement
- 130: gemeinsamer Ansaugstützen
- 150: Trägerfolie
- 152: elektronisches Bauelement / Halbleiter-Chip
- 200: pneumatische Bauelement-Aufnahmevorrichtung
- 210: Grundelement
- 212: Saugkanal
- 252: elektronisches Bauelement / Halbleiter-Chip

## Patentansprüche

1. Vorrichtung zum gleichzeitigen Aufnehmen einer Mehrzahl von elektronischen Bauelementen (152), insbesondere zum gleichzeitigen Aufnehmen von Halbleiter-Chips (152) aus einer Wafer-Anordnung, welche eine Trägerfolie (150) und an der Trägerfolie (150) anhaftende Halbleiter-Chips (152) aufweist, die Vorrichtung (100) aufweisend
• ein Grundelement (110), welches eine Mehrzahl von Saugkanälen (112) aufweist, die sich von einer Vorderseite (115) des Grundelements (110) hin zu einer Rückseite (116) des Grundelements (110) erstrecken,
• eine Mehrzahl von pneumatischen Verstellelementen (120), welche jeweils einem Saugkanal (112) zugeordnet sind,
wobei die pneumatischen Verstellelemente (120) jeweils derart eingerichtet sind, dass ein durch den jeweiligen Saugkanal (112) strömender Luftstrom zumindest teilweise blockiert wird, wenn die Stärke des Luftstromes einen vorgegebenen Schwellenwert überschreitet.

2. Vorrichtung nach Anspruch 1, bei der die Saugkanäle (112) in einem eindimensionalen oder einem zweidimensionalen Raster angeordnet sind.

3. Vorrichtung nach einem der Ansprüche 1 bis 2, zusätzlich aufweisend einen gemeinsamen Ansaugstutzen (130), welcher an der Rückseite (116) des Grundelements (110) angeordnet ist und pneumatisch mit der Mehrzahl von Saugkanälen (112) gekoppelt ist.

4. Vorrichtung nach einem der Ansprüche 1 bis 3, bei der die Vorderseite (115) des Grundelements (110) eine plane Oberfläche aufweist.

5. Vorrichtung nach einem der Ansprüche 1 bis 4, bei der die pneumatischen Verstellelemente (120) passive Komponenten sind.

6. Vorrichtung nach einem der Ansprüche 1 bis 5, bei der die pneumatischen Verstellelemente (120) innerhalb der Saugkanäle (112) angeordnet sind.

7. Vorrichtung nach einem der Ansprüche 1 bis 6, bei der die pneumatischen Verstellelemente verschiebbare Verschlusselemente (120) sind, welche jeweils durch eine mechanische Vorspannung eine Kraft in Richtung einer Ausgangsposition (120a) erfahren, in der der jeweilige Saugkanal (112) offen ist und welche jeweils durch eine Luftströmung innerhalb des jeweiligen Saugkanals (112) bei einer Überkompensation der mechanischen Vorspannung in eine Verschlussposition (120b) gedrückt werden können, in der der jeweilige Saugkanal (112) zumindest teilweise geschlossen ist.

8. Vorrichtung nach Anspruch 7, zusätzlich aufweisend
• eine Mehrzahl von Federelementen (122) zur Erzeugung der mechanischen Vorspannungen.

9. Verfahren zum gleichzeitigen Aufnehmen einer Mehrzahl von elektronischen Bauelementen (152), insbesondere zum gleichzeitigen Aufnehmen von Halbleiter-Chips (152) aus einer Wafer-Anordnung, das Verfahren aufweisend
• Heranführen einer Vorrichtung (100) nach einem der Ansprüche 1 bis 8 an eine Mehrzahl von aufzunehmenden elektronischen Bauelementen (152), welche an einer Trägerfolie (150) anhaften, so dass die Vorderseite (115) des Grundelements (110) an der Oberseite der Bauelemente (152) anliegt,
• Anlegen eines Unterdrucks an die Mehrzahl von Saugkanälen (112), so dass die Bauelemente (152) an der Vorderseite (115) des Grundelements (110) angesaugt werden, und
• Entfernen der Trägerfolie (150) von der Vorrichtung (100),
wobei die Bauelemente (152) an der Vorrichtung (100) verbleiben.

10. Verfahren nach Anspruch 9, zusätzlich aufweisend
• Abholen der Bauelemente (152) durch einen Bestückkopf eines Bestückautomaten, wobei der Bestückkopf mindestens eine Bauelement-Haltevorrichtung zum Aufnehmen eines elektronischen Bauelements aufweist.

11. Verfahren nach einem der Ansprüche 9 bis 10, zusätzlich aufweisend
• Wenden der Vorrichtung (100) zusammen mit der Mehrzahl von aufgenommenen Bauelementen (152).
